(19) Europäisches Patentamt
European Patent Office
Office européen des brevets

(11) **EP 3 265 754 B1**

(12) **EUROPÄISCHE PATENTSCHRIFT**

(45) Veröffentlichungstag und Bekanntmachung des Hinweises auf die Patenterteilung:
**09.10.2019 Patentblatt 2019/41**

(21) Anmeldenummer: **16704384.3**

(22) Anmeldetag: **28.01.2016**

(51) Int Cl.:
*G01D 3/08* *(2006.01)*    *G01R 33/09* *(2006.01)*
*G01K 7/20* *(2006.01)*    *G01R 35/00* *(2006.01)*
*G01R 31/28* *(2006.01)*    *G01R 17/10* *(2006.01)*

(86) Internationale Anmeldenummer:
**PCT/CH2016/000022**

(87) Internationale Veröffentlichungsnummer:
**WO 2016/138597 (09.09.2016 Gazette 2016/36)**

(54) **MESSBRÜCKENANORDNUNG MIT VERBESSERTER FEHLERERKENNUNG**

MEASURING BRIDGE ARRANGEMENT WITH IMPROVED ERROR DETECTION

DISPOSITIF DE PONT DE MESURE AVEC DÉTECTION D'ERREUR AMÉLIORÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.03.2015 CH 2862015**

(43) Veröffentlichungstag der Anmeldung:
**10.01.2018 Patentblatt 2018/02**

(73) Patentinhaber: **Tecpharma Licensing AG**
**3401 Burgdorf (CH)**

(72) Erfinder:
• **GENTZ, Michael**
**3400 Burgdorf (CH)**
• **BURI, Thomas**
**3400 Burgdorf (CH)**
• **LINDEGGER, Stefan**
**4950 Huttwil (CH)**
• **OBERLI, Markus**
**3422 Kirchberg (CH)**

(56) Entgegenhaltungen:
EP-A1- 2 511 713    WO-A1-89/05447
US-A- 5 461 319    US-B1- 6 545 613
US-B2- 8 149 002

**Beschreibung**

Gebiet der Erfindung

Diese Erfindung bezieht sich allgemein auf Messbrückenanordungen wie sie zum Erfassen von physikalischen Grössen wie z.B. Druck, Kraft, Temperatur, Magnetfeld verwendet werden. Solche Messbrückenanordungen enthalten mehrere resistive, piezoresistive oder magnetoresistive Elemente welche als Wheatstone-Brücke verschaltet sein können. Insbesondere bezieht sich die Erfindung auf Vorrichtungen und Verfahren zur Erkennung von Fehlerzuständen in der Messbrücke, den Zuleitungen und der Signalaufbereitung. Fehlererkennung ist unabdingbar in sicherheitskritischen Anwendungen wie beispielsweise in der Automobil- oder Medizintechnik. Beispielsweise müssen Verabreichungsgeräte wie Insulinpumpen oder automatische Injektoren über eine Messvorrichtung zur Erkennung einer Okklusion im Verabreichungspfad verfügen, wozu vorteilhaft Druck- oder Kraftsensoren eingesetzt werden. Da es sich bei der Okklusionserkennung um eine kritische Funktion handelt, muss ein Defekt oder eine Fehlfunktion der Messeinrichtung erkannt werden.

Hintergrund der Erfindung

In der PCT-Anmeldung, Internationale Veröffentlichungsnummer WO99/01777 A1 ist eine Schaltung zum Überwachen der Funktion einer piezoresistiven Wheatstone- Sensorbrückenschaltung offenbart. Wenn die verglichenen Signale um mehr abweichen als einen um einen akzeptablen Betrag gibt der Ausgang eines Fensterkomparators ein Alarmsignal aus. Die offenbarte Schaltung überwacht bis zu einem gewissen Ausmass die Brückenwiderstände sowie die Verbindung zu einem ASIC. Allerdings ist dieser zitierte Stand der Technik komplex und relativ teuer. Der Ansatz in dem zitierten Stand der Technik erfordert zwei separate Verarbeitungsschaltungen, die genau über der Zeit und Temperatur eingestellt und stabil sein müssen.

Aus der EP2269009 B1 ist ein Messumformer zur Prozessinstrumentierung bekannt, bei welchem der Zustand eines Substrats, das Messwiderstände eines Sensors zur Erzeugung eines Messsignals trägt, auf Veränderungen durch chemische Kontamination überwacht wird. Zusätzlich werden die Messwiderstände und ihre Anschlussleitungen auf Bruch, d. h. auf elektrische Unterbrechung, überwacht. Die Detektion eines Sensorbruchs kann beispielsweise über eine aufwändige Messung der Stromaufnahme der zu einer Wheatstone-Brücke verschalteten Messwiderstände erfolgen.

Die Erfindung aus der WO2014170051 A1 betrifft einen Messumformer zur Prozessinstrumentierung mit einem Sensor zur Erfassung einer physikalischen oder chemischen Grösse, wobei der Sensor zu einer Wheatstone-Brücke verschaltete Messwiderstände zur Erzeugung eines analogen Messsignals aufweist. Zur Durchführung einer Messumformerdiagnose wird ein Mittenabgriff zumindest eines ersten Spannungsteilers der Wheatstone-Brücke durch eine Reihenschaltung aus zumindest einem ersten Widerstand und einem ersten Schalter zeitweise mit Bezugspotential verbunden. Eine Ansteuer- und Auswerteeinrichtung ermittelt bei geöffnetem bzw. geschlossenem ersten Schalter die jeweiligen Werte eines digitalen Messsignals, das mittels eines Analog-Digital-Umsetzers aus dem analogen Messsignal gewonnen wurde. Liegt die Abweichung der beiden Werte ausserhalb eines vorbestimmten Toleranzbereichs, so wird ein Fehler des Messumformers insbesondere des Analog-Digital-Wandler (ADC) detektiert und angezeigt. Das hat den Vorteil, dass kein zweiter Analog-Digital-Wandler zur Überwachung des Analog-Digital-Wandler auf Fehlfunktionen erforderlich ist. Dieser Stand der Technik lehrt nicht eine vom Zustand des Sensors unabhängige Messumformerdiagnose.

Die EP2511713 offenbart eine Diagnostizierung eines elektronischen Brückensensors.

Aufgabe und Zusammenfassung der Erfindung

Es ist eine Aufgabe der vorliegenden Erfindung Vorrichtungen und Verfahren bereitzustellen, welche das Erfassen von Fehlern in einer Messbrückenanordnung einfacher und kostengünstiger erfüllen als die Lehren im oben erwähnten Stand der Technik. Eine weitere Aufgabe gemäss einer Weiterbildung der Erfindung ist die Bereitstellung eines Alarms, wenn ein Fehler in einer Messbrückenanordung auffritt.

Zusammengefasst kann die Erfindung nach einem ihrer strukturellen Aspekte wie folgt beschrieben werden: Eine Messbrückenanordnung für eine variable Eingangsgrösse, beispielsweise Kraft, enthaltend eine Messbrücke mit zwei Halbbrücken mit je einem Messanschluss zwischen denen abhängig vom Wert der Eingangsgrösse eine Brückendifferenzspannung als Messsignal abgreifbar ist. Weiter einen Referenzspannungsteiler mit zwei Prüfanschlüssen zwischen denen eine vorbestimmte Prüfdifferenzspannung als Prüfsignal abgreifbar ist. Weiter zwei steuerbare Umschalter für die Mess- bzw. Prüfsignale und einen Differenzverstärker dessen Ausgangssignal auf einen Analog-Digital-Wandler führen kann. Die Verstärkereingänge sind je mit einem Kondensator beschaltet. Erfindungsgemässe Ausführungsformen und Verfahren ergeben sich aus den unabhängigen Ansprüchen, vorteilhafte Weiterbildungen und Anwendungsfälle der Erfindung aus den abhängigen Ansprüchen.

Allgemeine Erfindungsbeschreibung

Die Messbrücke ist aus vier oder mehr insbesondere resistiven Elementen aufgebaut, wovon mindestens eines, vorteilhaft zwei Elemente ihren resistiven Wert durch den Einfluss der variierenden Eingangsgrösse ändern. Die Messbrücke wird gegenüber einem Bezugspotential von einer Referenzspannung gespiesen. Gegenüber Bezugspotential stellt sich bei abgestimmten Halbbrücken an den Messanschlüssen eine Gleichtaktspannung ein welche überlagert ist von der eingangsgrössenabhängigen Brückendifferenzspannung, welche als Messignal Ua zwischen den Halbbrücken abgreifbar ist.

Der Referenzspannungteiler ist aus drei oder mehr in Serie geschalteten Widerständen aufgebaut und wird gegen über einem Bezugspotential von einer weiteren Referenzspannung gespiesen, vorteilhaft von derselben Referenzspannung wie die Messbrücke. Bezüglich der Referenzspannung stellt sich über den Widerständen eine wertproportionale Teilspannung ein, von denen eine als Prüfsignal Up über einem oder mehreren Widerständen an Prüfanschlüssen abgreifbar ist.

Der Differenzverstärker weist zumindest zwei Verstärkereingänge auf, von denen einer ein nichtinvertierender und einer ein invertierender Verstärkereingang ist. Der Differenzverstärker hat eine vorbestimmte Spannungsverstärkung von 1 bis 100000, vorteilhaft 10 bis 10000, noch vorteilhafter 100 bis 1000, beispielsweise 123. Die Eingangswiderstände der Verstärkereingänge sind vorteilhaft um ein Vielfaches höher als die Innenwiderstände der Messbrücke und des Referenzspannungsteilers. Der am Verstärkerausgang verfügbare Ausgangsspannungsarbeitsbereich ist vorteilhaft durch Einsatz eines sogenannten "Rail to Rail Instrumentenverstärkers" unverzerrt nutzbar über annähernd den ganzen Spannungsbereich vom Bezugspotential bis zur einem Verstärkerspeisepotential, welches vorteilhaft der Referenzspannung der Messbrücke entspricht oder zu dieser in einem vorbestimmten proportionalen Verhältnis steht.

Die Spannung am Verstärkerausgang kann einem Analog-Digital-Wandler zugeführt werden. Dessen Referenzspannung ist vorteilhaft identisch mit dem Verstärkerspeisepotential. Der Analog-Digital-Wandler übersetzt die signalproportionalen Spannungswerte an seinem Eingang bei Bedarf oder periodisch in diskrete numerische Werte, wobei ein minimaler Wert dem Bezugspotential und ein maximaler Wert der Referenzspannung entsprechen kann. Diese Werte stehen für eine nachfolgende digitale Bearbeitung, insbesondere für Vergleiche, Berechnungen, Speicherung oder Anzeige zur Verfügung. Insbesondere kann eine solche weitere Verarbeitung programmgesteuert in einem Kontroller oder Computer erfolgen.

Über Umschalter, welche vorteilhaft in Halbleitertechnik als sogenannte "Analogswitches" ausgeführt sind kann ein Verstärkereingang wahlweise mit einem Messanschluss an der Messbrücke oder einem Prüfanschluss am Referenzspannungsteiler verbunden werden. Dabei sind der nichtinvertierende und der invertierende Eingang des Differenzverstärkers an je einen Umschalter angeschlossen. Sind beide Umschalter in ihrer normalen ersten Position können die Umschalter beispielsweise das Messignal von der Messbrücke an die Verstärkereingänge anlegen. In ihrer betätigten zweiten Position können die Umschalter sodann beispielsweise das Prüfsignal vom Referenzspannungsteiler an die Verstärkereingänge anlegen. Erfindungsgemäss können die Umschalter weiter auch so betätigt oder festgelegt sein, dass beispielsweise ein erster Umschalter einen nicht invertierenden Verstärkereingang an einen Messanschluss an der Messbrücke verbindet und gleichzeitig ein zweiter Umschalter einen invertierenden Verstärkereingang an den Prüfanschluss am Referenzspannungsteiler verbindet. Geeignete Analogswitch stehen vorteilhaft in Gruppen integriert als sogenannte "Multiplexer" zu Verfügung. Individuelles oder gemeinsames Betätigen oder Festlegen der Schalterposition der Umschalter kann vorteilhaft durch digitale Signale erfolgen, welche von einem Kontroller oder Computer programmgesteuert sein können.

Erfindungsgemäss sind an den Verstärkereingängen Kondensatoren vorgesehen. Diese übernehmen mit ausreichender Genauigkeit das Potential eines zugeschalteten Mess- oder Prüfanschlusses bekannterweise abhängig von ihrer Kapazität C und dem wirksamen Innenwiderstand R der angeschlossenen Spannungsquelle nach einigen Zeitkonstanten $\tau$, vorteilhaft nach $5\tau$ oder gar $10\tau$, wobei sich die Zeitkonstante berechnet nach der Formel:

$$\tau = RC$$

Ein zugeschaltetes Mess- oder Prüfpotential kann also nach einer entsprechenden Ladezeit mit genügender Genauigkeit verstärkt und wie oben beschrieben weiter verarbeitet werden.

Wird die Spannungsquelle weggeschaltet oder ist eine Verbindungsleitung unterbrochen bleibt das übernommene Potential durch die Kondensatorladung am Verstärkereingang zuerst bestehen bzw. wird vergleichsweise mit der Aufladung nur sehr langsam abnehmen und kann am Anfang der langsamen Entladung mit genügender Genauigkeit verstärkt und wie oben beschrieben weiter verarbeitet werden. Die Zeitkonstante $\tau'$ berechnet sich bei identischer Kapazität C wieder nach:

$$\tau' = R'C$$

Dabei ist für die langsame Entladung der vorteilhaft sehr hohe wirksame Innenwiderstand R' der sich durch den Verstärkereingangswiderstand, die Kondensatorisolation, die Schalterisolation sowie durch weitere Isolationswiderstände ergibt die bestimmende Grösse. Erfindungsgemäss soll also der wirksame Innenwiderstand R der Messbrücke und des Referenzspannungsteilers erheblich kleiner gewählt werden als der wirksame Innenwiderstand R', beispielsweise 100 mal bis 1 000 000 mal kleiner. Der Kondensator kann vorteilhaft eine Kapazität von 1 bis 100nF aufweisen, beispielsweise 10 nF. Bei sehr hohen bzw. sehr tiefen wirksamen Innenwiderständen kann die Kapazität entsprechend auch noch kleiner bzw. noch grösser gewählt werden.

Die beschriebene Messbrückenanordnung erlaubt ein erstes erfindungsgemässes Verfahren zur Diagnose der Signalverarbeitung, insbesondere des Differenzverstärkers und des Analog-Digital-Wandlers sowie der Integrität der Verbindungen dieser Elemente. Der Referenzspannungsteiler ist dabei durch entsprechende Wahl der Widerstandswerte vorteilhaft so dimensioniert, dass der Spannungswert des an den Prüfanschlüssen abgreifbaren Prüfsignals grösser ist als die als Messsignal im Normalbetrieb maximal entstehende Brückendifferenzspannung Uamax. Dabei ist die Spannungsverstärkung G des Differenzverstärkers so zu dimensionieren, dass die Ausgangsspannung kleiner ist als das obere Ende des Ausgangsspannungsarbeitsbereichs, vorteilhaft in der Nähe des oberen Endes des Ausgangsspannungsarbeitsbereichs. Entsprechend kann ein erster Sollwertbereichs für plausible Werte der Differenzspannung zwischen dem ersten Prüfanschluss und dem zweiten Prüfanschluss multipliziert mit der Spannungsverstärkung festgelegt werden. Im Betrieb können nun bei Bedarf die Umschalter durch die Steuersignale auf die Prüfanschlüsse gelegt werden und nach der oben beschrieben genügend langen Ladezeit des Kondensators kann der Spannungswert am Verstärkerausgang ausgewertet und ein erster Fehlerzustand erkannt werden wenn sich der Spannungswert ausserhalb des ersten Sollwertbereichs einstellt.

Die beschriebene Messbrückenanordnung erlaubt ein zweites erfindungsgemässes Verfahren zur Diagnose der Signalaufbereitung, insbesondere in der Messbrücke sowie der Integrität der Verbindungen der Messbrücke mit dem Differenzverstärker. Der Referenzspannungsteiler ist dabei durch entsprechende Wahl der Widerstandswerte vorteilhaft so dimensioniert, dass der Spannungswert des an den Prüfanschlüssen abgreifbaren Prüfsignals grösser ist als die als Messsignal im Normalbetrieb maximale entstehende Brückendifferenzspannung Uamax. Dabei ist die Spannungsverstärkung G des Differenzverstärkers so zu dimensionieren, dass die maximale Ausgangsspannung kleiner ist als das obere Ende des Ausgangsspannungsarbeitsbereichs, vorteilhaft in der Nähe des oberen Endes des Ausgangsspannungsarbeitsbereichs, besonders vorteilhaft definiert die so dimensionierte Ausgangsspannung das obere Ende des Ausgangsspannungsarbeitsbereichs. Weiter sind der Referenzspannungsteiler und die Messbrücke durch entsprechende Wahl der Widerstandswerte so dimensioniert, dass der Spannungswert eines Gleichtaktsignals Ugt der beiden Halbbrücken entweder um mindestens die Hälfte des Betrags der maximalen Messdifferenzspannung Uamax grösser ist als der Spannungswert am ersten Prüfanschluss +UR oder um mindestens die Hälfte des Betrags der maximalen Messdifferenzspannung Uamax kleiner ist als der Spannungswert am zweiten Prüfanschluss -UR.

Im Betrieb können die Umschalter für eine Prüfphase durch die Steuersignale auf die Prüfanschlüsse gelegt werden und nach der oben beschrieben genügend langen Ladezeit der Kondensatoren stellt sich an den Kondensatoren bzw. an den Verstärkereingängen je ein vom Gleichtaktsignals Ugt abweichendes Potential ein. Anschliessend können die Umschalter für eine Messphase durch die Steuersignale auf die Messanschlüsse gelegt werden. Bei intakten Zuleitungen und nach der oben beschrieben genügend langen Ladezeit der Kondensatoren stellt sich an den Kondensatoren bzw. an den Verstärkereingängen je ein Potential in der Höhe des Gleichtaktsignals Ugt ein überlagert vom der aktuellen Messdifferenzspannung Ua. Am Verstärkerausgang Vout steht das verstärkte Messsignal an, welches über dem unteren Ende und unter dem oberen Ende des Ausgangsspannungsarbeitsbereichs liegen muss. Ist dieses Kriterium nicht erfüllt liegt ein zweiter Fehlerzustand vor, welcher insbesondere auch durch eine verstimmte oder defekte Messbrücke verursacht sein kann.

Ist eine der beiden Signalleitungen von der Messbrücke zum Differenzverstärker unterbrochen verbleibt der betroffene Verstärkereingang aufgrund der Kondensatorladung auf dem Potential des Prüfanschlusses. Der andere Verstärkereingang übernimmt das Potential des Messanschlusses. Aufgrund der obigen Dimensionierung ergibt sich zwischen den Verstärkereingängen eine Potentialdifferenz welche grösser ist als die maximale Messdifferenzspannung Uamax. Durch die Spannungsverstärkung G entsteht am Verstärkerausgang eine Spannung ausserhalb des Ausgangsspannungsarbeitsbereichs oder der Verstärker wird übersteuert und geht mit seinem Ausgangwert "in Anschlag", d.h. auf annähernd Verstärkerspeisepotential bzw. Referenzpotential oder Bezugspotential was beides als dritter Fehlerzustand erkannt werden kann.

Sind beide Signalleitungen unterbrochen verbleiben beide betroffenen Verstärkereingänge aufgrund der Kondensatorladungen nach dem Umschalten von der Prüfphase auf die Messphase auf den Potentialen der Prüfanschlüsse obwohl diese nicht mehr verbunden sind. Durch die Spannungsverstärkung verbleibt am Verstärkerausgang eine Spannung innerhalb des ersten Sollwertbereichs was als vierter Fehlerzustand erkannt werden kann.

Erkannte Fehlerzustände, insbesondere erste bis vierte Fehlerzustände können vorteilhaft zusammen mit den Fehlerumständen, wie Betriebsart und Zeit/Datum abgespeichert werden zwecks weiterer oder späterer Bearbeitung. Gleichzeitig oder verzögert kann ein Auslösen eines Alarms und/oder eine Betriebszustandsänderung erfolgen oder eine Signalisierung oder Datenausgabe erfolgen.

Kurze Beschreibung der Zeichnungen

Fig. 1 zeigt schematisch eine Ausführungsform der erfindungsgemässen Messbrückenanordnung

Fig. 2 zeigt schematisch eine bevorzugte Ausführungsform der Signalauswertung für eine Messbrücke

Detailbeschreibung der Ausführungsformen

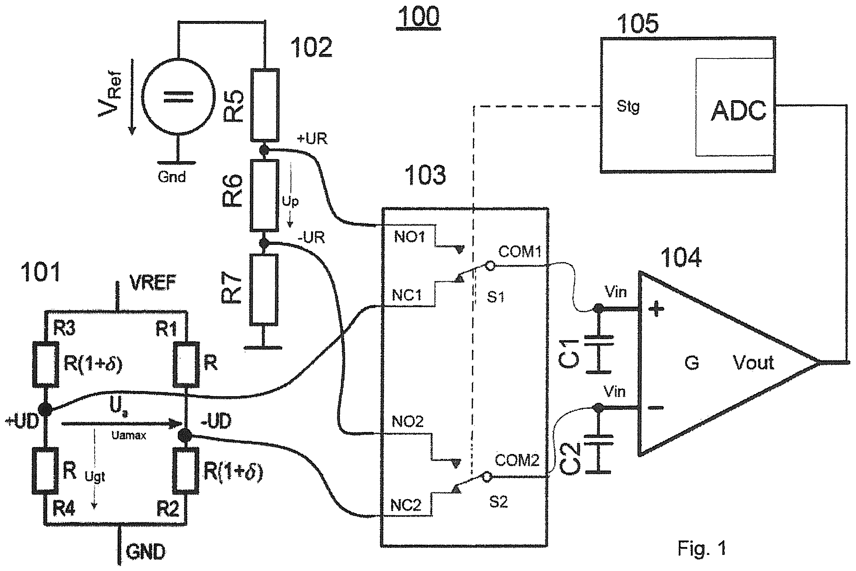

Fig. 1 zeigt in Übereinstimmung mit einer ersten Ausführungsform der Erfindung eine Messbrückenanordnung 100 enthaltend eine Messbrücke 101, eine Referenzspannungsquelle Vref mit Referenzspannungsteiler 102, einen Multiplexer 103 enthaltend zwei steuerbare Umschalter S1 und S2, einen Differenzverstärker 104 dessen Eingänge Vin+ und Vin- mit den Kondensatoren C1 und C2 gegen Bezugspotential beschaltet sind und der einen Ausgang Vout aufweist, einen Kontroller 105 enthaltend einen integriertem Analog-Digital-Wandler ADC und einen digitalen Steuerausgang Stg.

Die Messbrücke 101 wird gegenüber einem Bezugspotential Gnd mit dem Referenzpotential Vref gespiesen. Zwei resistive Elemente R3 und R4 bilden eine erste Halbbrücke mit einem Messanschluss +UD wobei R4 einen festen Widerstandswert aufweist und R3 seinen Widerstand aufgrund einer veränderlichen äusseren physikalischen Grösse ändert. Zwei weitere resistive Elemente R1 und R2 bilden eine zweite Halbbrücke mit einem Messanschluss -UD wobei R1 einen festen Widerstandswert aufweist und R2 seinen Widerstand aufgrund einer veränderlichen äusseren physikalischen Grösse ändert. Vorzugsweise ist die Brücke so abgestimmt, dass die Brückendifferenzspannung Ua bei minimaler oder maximaler äusserer Grösse dem Wert null nahekommt. Gegenüber Bezugspotential stellt sich dabei an den Messanschlüssen die Gleichtaktspannung Ugt ein.

Der Referenzspannungsteiler 102 ist aus einer Serieschaltung der drei Widerstände R5, R6, R7 gebildet und liegt zwischen Bezugspotential Gnd und Referenzpotential Vref. Zwischen R5 und R6 befindet sich der Prüfanschluss +UR und zwischen R6 und R7 der Prüfanschluss -UR. Eine Prüfspannung Up kann zwischen -UR und +UR abgegriffen werden.

Der Umschalter S1 im Multiplexer 103 ist mit seinem gemeinsamen Anschluss COM1 mit dem nichtinvertierenden Verstärkereingang Vin+ verbunden, sein Arbeitskontakt NO1 ist mit dem Prüfanschluss +UR, sein Ruhekontakt NC1 mit dem Messanschluss +UD verbunden. Die Steuerleitung des Umschalters S1 ist an einen digitalen Ausgang des Kontrollers 105 angeschlossen. Der Umschalter S2 im Multiplexer 103 ist mit seinem gemeinsamen Anschluss COM2 mit dem invertierenden Verstärkereingang Vin- verbunden, sein Arbeitskontakt NO2 ist mit dem Prüfanschluss -UR, sein Ruhekontakt NC2 mit dem Messanschluss -UD verbunden. Die Steuerleitung des Umschalters S2 ist an einen digitalen Ausgang Stg des Kontrollers 105 angeschlossen.

Der Differenzverstärker 104, vorzugsweise eine integrierte Schaltung vom Typ Instrumentenverstärker mit dem nichtinvertierenden Verstärkereingang Vin+ und dem invertierenden Verstärkereingang Vin- weist eine über ein externes Element bestimmbare Spannungsverstärkung G und einen Ausgang Vout auf, welcher die mit G multiplizierte Differenz der Potentiale an den Verstärkereingängen ausgibt, solange sich dieser Wert als Potential zwischen Bezugspotential und Verstärkerspeisespannung darstellen lässt. Das Potential an Vout wird an den analogen Eingang des Analog-Digital-Wandlers ADC im Kontroller 105 geführt.

Der Kontroller 105 kann eine festverdrahtete Logik sein, vorzugsweise hingegen ein Mikrokontroller oder ASIC welcher eine programmgesteuerte Logik implementiert. Der Kontroller 105 steuert in der gezeigten Ausführungsform über den mindestens einen digitalen Ausgang Stg den Multiplexer 103 und veranlasst die Analog-Digital-Wandlung und die Auswertung und Verarbeitung der gewandelten Messwerte.

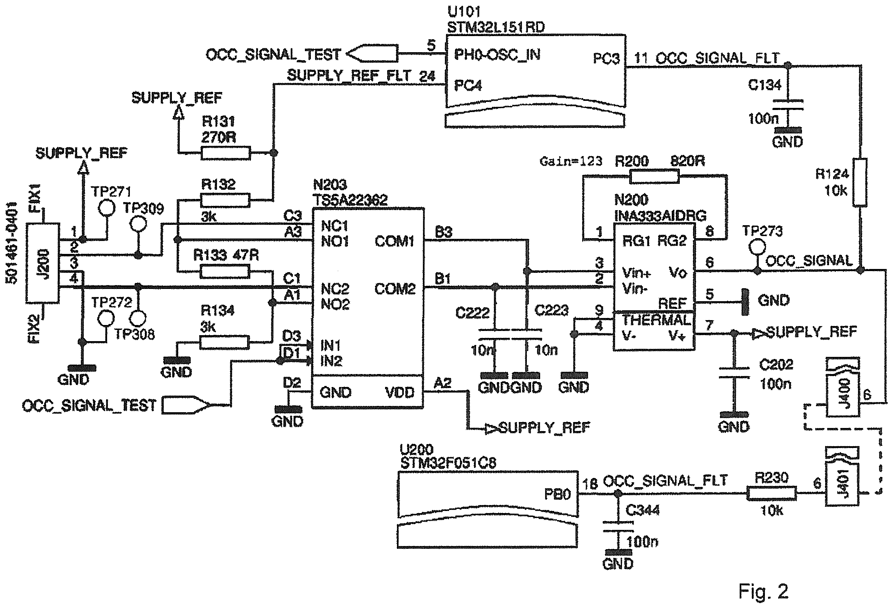

Fig. 2 zeigt in Übereinstimmung mit einer zweiten, bevorzugten Ausführungsform der Erfindung einen lösbaren Anschluss J200 für die Messbrücke (nicht gezeigt), eine Referenzspannungsquelle SUPPLY_REF mit Referenzspannungsteiler bestehen aus den Widerständen R132, R133, R134, einen Multiplexer N203 enthaltend zwei steuerbare Umschalter, einen Differenzverstärker N200 dessen Eingänge Vin+ und Vin- mit den Kondensatoren C223 und C222 gegen Bezugspotential beschaltet sind und der einen Ausgang Vo aufweist, einen Kontroller U101 enthaltend einen integriertem Analog-Digital-Wandler.

Die Funktion und Struktur der zweiten Ausführungsform entspricht prinzipiell der ersten Ausführungsform. Die im Folgenden angegebenen konkreten Dimensionierungen sollen Aspekte der Erfindung illustrieren und stellen lediglich eine mögliche Ausführungsform dar. Die Messbrücke (nicht abgebildet) ist an der Buchse J200 angeschlossen. Der Analogmultiplexer N203 verfügt über zwei integrierte, zweipolige, niederohmige Umschalter mit geringem Crosstalk. Die Leitung OCC_SIGNAL_TEST führt das Steuersignal des Masterprozessors zum Steuereingang des Analogmultiplexers N203. Wenn OCC_SIGNAL_TEST = Low: Die Eingänge NC sind mit den Ausgängen COM verbunden, die Eingänge NO sind offen. Wenn OCC_SIGNAL_TEST = High: Die Eingänge NO sind mit den Ausgängen COM verbunden, die Eingänge NC sind offen.

R131 bis R134 bilden an Referenzpotential SUPPLY_REF z.B. 3.0 V eine Spannungsteilerkette. An R133 wird eine Differenzspannung von 22.3 mV mit einem Gleichtaktpegel von 1.425 V generiert. Die beiden Potentiale von R133 werden an die NO1 und NO2-Anschlüsse des Analogmultiplexers N203 geführt. Bei OCC_SIGNAL_TEST = High wird das mit der Spannungsteilerkette generierte Prüfsignal an die beiden Eingänge des Verstärkers N200 gelegt. Bei der eingestellten Verstärkung mit einem Gain = 123 erzeugt N200 ein Referenzsignal von etwa 2.75 V. Bei OCC_SIGNAL_TEST = Low werden die beiden Ausgangssignale der Messbrücke an die Eingänge des Verstärkers N200 gelegt. In diesem Modus entspricht die Schaltung der sonst üblichen Grundschaltung zur Auswertung der Messbrücken-Ausgangssignale.

Die beiden Kondensatoren C222 und C223 dienen der Fehlerdetektion bei Unterbrechung einer oder mehrerer Verbindungsleitungen zur Messbrücke. Die Wirkungsweise ist wie folgt: Zunächst wird das Prüfsignal ausgewertet. Dadurch erhalten die beiden Kondensatoren ein definiertes Potential im Bereich des Gleichtaktpegels von etwa 1.425 V.

Wenn der Multiplexer umgeschaltet wird, übernehmen die beiden Kondensatoren bei intakter Verbindung in kürzester Zeit das Potential der niederohmigen Messbrücke als Messdifferenzspannung mit einem Gleichtaktpegel von etwa 1.5 V. Am Ausgang von N200 liegt die verstärkte Messdifferenzspannung an. Wenn hingegen eine Signal-Leitung unterbrochen ist, verbleibt das Potential des betroffenen Kondensators auf dem ursprünglichen Pegel. Es stellt sich an den Verstärkereingängen deshalb eine vergleichsweise hohe Differenzspannung von ca. 75 mV ein, die den Instrumentenverstärker N200 mit Gain = 123 in den Anschlag bringt (Bezugspotential GND 0 V oder Referenzpotential SUPPLY_REF 3 V).

Bei Unterbrechung beider Messbrückensignalleitungen bleibt das Prüfsignal am Ausgang von N200 bestehen. Dieses hat verglichen mit den normalen Messwerten einen inakzeptabel hohen Wert.

Die Ausgangsspannung OCC_SIGNAL des Differenzverstärkers wird über einen analogen Tiefpass R124, C134 dem Analog-Digital-Wandler im Kontroller U101 zugeführt. Alternativ oder ergänzend kann die Ausgangsspannung OCC_SIGNAL auch einer zweiten unabhängigen Filterung und Weiterverarbeitung in einem weiteren Kontroller zugeführt werden R230, C344, U200.

**Patentansprüche**

1. Messbrückenanordnung (100), enthaltend eine Messbrücke (101) mit zumindest einer ersten Halbbrücke mit einem ersten Messanschluss (+UD), und einer zweiten Halbbrücke mit einem zweiten Messanschluss (-UD), einen Referenzspannungsteiler (102) mit zumindest einem ersten und einem zweiten Prüfanschluss (+UR, -UR), einen Differenzverstärker (104) mit zumindest einem ersten und einem zweiten Verstärkereingang (Vin+, Vin-) und zumindest einem Verstärkerausgang (Vout) und einer Spannungsverstärkung (G) und einem Ausgangsspannungsarbeitsbereich **dadurch gekennzeichnet, dass** der erste Verstärkereingang (Vin+) mit einem ersten Kondensator (C1) und der zweite Verstärkereingang (Vin-) mit einem zweiten Kondensator (C2) beschaltet ist und die Verstärkereingänge wahlweise mit den Messanschlüssen oder den Prüfanschlüssen verbindbar sind.

2. Messbrückenanordnung (100) gemäss Anspruch 1, wobei ein erster Umschalter (S1) in einer Messphase den ersten Messanschluss (+UD) und in einer Prüfphase den ersten Prüfanschluss (+UR) mit dem ersten Verstärkereingang (Vin+) verbindet und ein zweiter Umschalter (S2) in der Messphase den zweiten Messanschluss (-UD) und in der Prüfphase den zweiten Prüfanschluss (-UR) mit dem zweiten Verstärkereingang (Vin-) verbindet.

3. Messbrückenanordnung (100) gemäss Anspruch 2, wobei die Messbrücke (101) und der Referenzspannungsteiler (102) mit einem Referenzpotential (Vref) gegenüber einem Bezugspotential (Gnd) betrieben wird wobei der Betrag einer maximalen Messdifferenzspannung (Uamax) zwischen dem ersten Messanschluss (+UD) und dem zweiten Messanschluss (-UD) multipliziert mit der Spannungsverstärkung (G) und der Betrag einer Referenzdifferenzspannung zwischen dem ersten Prüfanschluss (+UR) und dem zweiten Prüfanschluss (-UR) multipliziert mit der Spannungsverstärkung (G) Werte innerhalb des Ausgangsspannungsarbeitsbereichs des Differenzverstärkers annehmen.

4. Messbrückenanordnung (100) gemäss Anspruch 3, wobei der Spannungswert eines Gleichtaktsignals (Ugt) der beiden Halbbrücken entweder um mindestens die Hälfte des Betrags der maximalen Messdifferenzspannung (Uamax) grösser ist als der Spannungswert am ersten Prüfanschluss (+UR) oder um mindestens die Hälfte des Betrags der maximalen Messdifferenzspannung (Uamax) kleiner ist als der Spannungswert am zweiten Prüfanschluss (-UR).

5. Messbrückenanordnung (100) gemäss Anspruch 4, wobei erste Zeitkonstantenwerte ($\tau 1$, $\tau 2$), welche sich jeweils aus der Kapazität des ersten und zweiten Kondensators und des Innenwiderstandes des ersten und zweiten Verstärkereingangs ergeben erheblich grösser sind als zweite Zeitkonstantenwerte ($\tau 1'$, $\tau 2'$), welche sich jeweils aus der Kapazität des ersten und zweiten Kondensators und des Innenwiderstandes der ersten und zweiten Halbbrücke ergeben.

6. Messbrückenanordnung (100) gemäss Anspruch 5, wobei ein Kontroller (105) Messphase und Prüfphase der Umschalter (S1, S2) über ein Steuersignal (Stg) festlegt und dabei den jeweiligen Spannungswert am Verstärkerausgang (Vout) auswerten kann.

7. Messbrückenanordnung (100) gemäss Anspruch 6, wobei der Kontroller ein Computerprogramm ausführt.

**8.** Verfahren zur Fehlererkennung in einer Messbrückenanordnung gemäss Anspruch 2 enthaltend folgende Schritte: Anlegen eines Referenzpotentials (Vref) an die Messbrücke (101) und den Referenzspannungsteiler (102), Festlegen der Prüfphase mittels der Umschalter (S1, S2), Erkennen eines Fehlerzustands wenn sich der Spannungswert am Verstärkerausgang (Vout) ausserhalb eines ersten Sollwertbereichs für plausible Werte der Differenzspannung zwischen dem ersten Prüfanschluss (+UR) und dem zweiten Prüfanschluss (-UR) multipliziert mit der Spannungsverstärkung (G) einstellt.

**9.** Verfahren zur Fehlererkennung gemäss Anspruch 8 enthaltend zusätzlich folgende Schritte:, Festlegen der Messphase mittels der Umschalter (S1, S2), Abwarten einer Zeit welche ein Vielfaches von zweiten Zeitkonstanten beträgt, welche sich jeweils aus der Kapazität des ersten und zweiten Kondensators und des Innenwiderstandes der ersten und zweiten Halbbrücke ergeben aber ein Vielfaches kleiner ist als erste Zeitkonstanten welche sich jeweils aus der Kapazität des ersten und zweiten Kondensators und des Innenwiderstandes des ersten und zweiten Verstärkereingangs ergeben, Erkennen eines Fehlerzustands wenn sich der Spannungswert am Verstärkerausgang (Vout) ausserhalb eines zweiten Sollwertbereichs für plausible Werte der Differenzspannung zwischen dem ersten Messanschluss (+UD) und dem zweiten Messanschluss (-UD) multipliziert mit der Spannungsverstärkung (G) oder innerhalb des ersten Sollwertbereichs einstellt.

**10.** Verfahren zur Fehlererkennung gemäss Anspruch 8 oder 9 enthaltend zusätzlich folgende Schritte: Abspeichern eines erkannten Fehlerzustandes zwecks weiterer Bearbeitung und/oder Auslösen eines Alarms und/oder Signalisieren einer Betriebszustandsänderung.

**11.** Verfahren nach Anspruch 8, 9 oder 10, wobei dieses in einem Computerprogramm codiert ist, welches von einem Kontroller ausgeführt wird.

**12.** Verfahren nach Anspruch 8, 9, 10 oder 11, wobei es in einer Vorrichtung zu parenteralen Verabreichung eines Medikaments ausgeführt wird.

**Claims**

**1.** A measuring bridge arrangement (100) including a measuring bridge (101) with at least one first half bridge with a first measuring terminal (+UD) and a second half bridge with a second measuring terminal (-UD), a reference voltage divider (102) with at least a first and a second test terminal (+UR, -UR), a differential amplifier (104) with at least a first and a second amplifier input (Vin+, Vin-) and at least one amplifier output (Vout) and a voltage gain (G) and an output voltage working range, **characterised in that** the first amplifier input (Vin+) is connected to a first capacitor (C1) and the second amplifier input (Vin-) is connected to a second capacitor (C2) and the amplifier inputs can be selectively connected to the measuring terminals or the test terminals.

**2.** A measuring bridge arrangement (100) according to claim 1 wherein a first change-over switch (S1) in a measurement phase connects the first measuring terminal (+UD) to the first amplifier input (Vin+) and in a test phase it connects the first test terminal (+UR) to the first amplifier input (Vin+) and a second change-over switch (S2) in the measurement phase connects the second measuring terminal (-UD) to the second amplifier input (Vin-) and in the test phase it connects the second test terminal (-UR) to the second amplifier input (Vin-).

**3.** A measuring bridge arrangement (100) according to claim 2 wherein the measuring bridge (101) and the reference voltage divider (102) are operated with a reference potential (Vref) with respect to a referential potential (Gnd), wherein the value of a maximum measuring difference voltage (Uamax) between the first measuring terminal (+UD) and the second measuring terminal (-UD) multiplied by the voltage gain (G) and the value of a reference differential voltage between the first test terminal (+UR) and the second test terminal (-UR) multiplied by the voltage gain (G) assume values within the output voltage working range of the differential amplifier.

**4.** A measuring bridge arrangement (100) according to claim 3 wherein the voltage value of a common mode signal (Ugt) of the two half bridges is either greater than the voltage value at the first test terminal (+UR) by at least half the value of the maximum measuring differential voltage (Uamax) or is less than the voltage value at the second test terminal (-UR) by at least half the value of the maximum measuring differential voltage (Uamax).

**5.** A measuring bridge arrangement (100) according to claim 4 wherein first time constant values (r1, r2) which respectively result from the capacitance of the first and second capacitors and the internal resistance of the first and second amplifier inputs are considerably greater than second time constant values (r1', r2') which respectively result from the capacitance of the first and second capacitors and the internal resistance of the first and second half bridges.

**6.** A measuring bridge arrangement (100) according to claim 5 wherein a controller (105) sets the measuring phase and the test phase of the change-over switches (S1, S2) by way of a control signal (Stg) and in so doing can evaluate the respective voltage value at the amplifier output (Vout).

7. A measuring bridge arrangement (100) according to claim 6 wherein the controller executes a computer program.

8. A method of error detection in a measuring bridge arrangement according to claim 2 including the following steps: applying a reference potential (Vref) to the measuring bridge (101) and the reference voltage divider (102), setting the test phase by means of the change-over switches (S1, S2), detecting an error state if the voltage value at the amplifier output (Vout) is set outside a first target value range for plausible values of the differential voltage between the first test terminal (+UR) and the second test terminal (-UR) multiplied by the voltage gain (G).

9. An error detection method according to claim 8 additionally including the following steps: setting the measurement phase by means of the change-over switches (S1, S2), awaiting a time which is a multiple of second time constants which respectively result from the capacitance of the first and second capacitors and the internal resistance of the first and second half bridges but is a multiple smaller than first time constants which respectively result from the capacitance of the first and second capacitors and the internal resistance of the first and second amplifier inputs, detecting an error state if the voltage value at the amplifier output (Vout) is set outside a second target value range for plausible values of the differential voltage between the first measuring terminal (+UD) and the second measuring terminal (-UD) multiplied by the voltage gain (G) or within the first target value range.

10. An error detection method according to claim 8 or claim 9 additionally including the following steps: storing a detected error state for the purposes of further processing and/or triggering of an alarm and/or signaling a change in operating state.

11. A method according to claim 8, claim 9 or claim 10 wherein it is encoded in a computer program which is executed by a controller.

12. A method according to claim 8, claim 9, claim 10 or claim 11 wherein it is carried out in an apparatus for parenteral administration of a medication.

**Revendications**

1. Ensemble de pont de mesure (100), contenant un pont de mesure (101) avec au moins un premier demi-pont avec un premier raccord de mesure (+UD) et un second demi-pont avec un second raccord de mesure (-UD), un diviseur de tension de référence (102) avec au moins un premier et un second raccord de contrôle (+UR, - UR), un amplificateur de différence (104) avec au moins une première et une seconde entrée d'amplificateur (Vin+, Vin-) et au moins une sortie d'amplificateur (Vout) et une amplification de tension (G) et une plage de travail de tension de sortie, **caractérisé en ce que** la première entrée d'amplificateur (Vin+) est branchée avec un premier condensateur (C1) et la seconde entrée d'amplificateur (Vin-) est branchée avec un second condensateur (C2) et les entrées d'amplificateur peuvent être reliées sélectivement aux raccords de mesure ou aux raccords de contrôle.

2. Ensemble de pont de mesure (100) selon la revendication 1, dans lequel un premier commutateur (S1) relie, dans une phase de mesure, le premier raccord de mesure (+UD) et, dans une phase de contrôle, le premier raccord de contrôle (+UR) à la première entrée d'amplificateur (Vin+) et un second commutateur (S2) relie dans la phase de mesure le second raccord de mesure (-UD) et dans la phase de contrôle le second raccord de contrôle (-UR) à la seconde entrée d'amplificateur (Vin-).

3. Ensemble de pont de mesure (100) selon la revendication 2, dans lequel le pont de mesure (101) et le diviseur de tension de référence (102) fonctionnent avec un potentiel de référence (Vref) par rapport à un potentiel nominal (Gnd), dans lequel la valeur d'une tension de différence de mesure maximale (Uamax) entre le premier raccord de mesure (+UD) et le second raccord de mesure (-UD), multipliée par l'amplification de tension (G) et la valeur d'une tension de différence de référence entre le premier raccord de contrôle (+UR) et le second raccord de contrôle (-UR), multipliée par l'amplification de tension (G), adoptent des valeurs à l'intérieur de la plage de travail de tension de sortie de l'amplificateur de différence.

4. Ensemble de pont de mesure (100) selon la revendication 3, dans lequel la valeur de tension d'un signal de mode commun (Ugt) des deux demi-ponts est soit supérieure d'au moins la moitié de la valeur de la tension de différence de mesure maximale (Uamac) à la valeur de tension au niveau du premier raccord de contrôle (+UR) soit inférieure d'au moins la moitié de la valeur de la tension de différence de mesure maximale (Uamax) à la valeur de tension au niveau du second raccord de contrôle (-UR).

5. Ensemble de pont de mesure (100) selon la revendication 4, dans lequel des premières valeurs de constante de temps (T1, T2), lesquelles résultent respectivement de la capacité du premier et du second condensateur et de la résistance intérieure de la première et de la seconde entrée d'amplificateur, sont nettement supérieures à des secondes valeurs de constante de temps (T1', T2'), lesquelles résultent respectivement de la capacité du premier et du second condensateur et de la résistance intérieure du premier et du second demi-pont.

6. Ensemble de pont de mesure (100) selon la revendication 5, dans lequel un contrôleur (105) fixe une phase de mesure et une phase de contrôle des commutateurs (S1, S2) par l'intermédiaire d'un signal de commande (Stg) et peut évaluer ce faisant la valeur de tension respective au niveau de la sortie d'amplificateur (Vout).

7. Ensemble de pont de mesure (100) selon la revendication 6, dans lequel le contrôleur exécute un programme informatique.

8. Procédé servant à identifier des erreurs dans un ensemble de pont de mesure selon la revendication 2, contenant des étapes suivantes : application d'un potentiel de référence (Vref) au niveau du pont de mesure (101) et du diviseur de tension de référence (102), fixation de la phase de contrôle au moyen des commutateurs (S1, S2), identification d'un état d'erreur quand la valeur de tension au niveau de la sortie d'amplificateur (Vout) se règle en dehors d'une première plage de valeurs théoriques pour des valeurs plausibles de la tension de différence entre le premier raccord de contrôle (+UR) et le second raccord de contrôle (-UR) multipliée par l'amplification de tension (G).

9. Procédé servant à identifier des erreurs selon la revendication 8 contenant en supplément des étapes suivantes : fixation de la phase de mesure au moyen des commutateurs (S1, S2), attente d'une durée, qui est un multiple de secondes constantes de temps, lesquelles résultent respectivement de la capacité du premier et du second condensateur et de la résistance intérieure du premier et du second demi-pont, un multiple étant toutefois inférieur à des premières constantes de temps, lesquelles résultent respectivement de la capacité du premier et du second condensateur et de la résistance intérieure de la première et de la seconde entrée d'amplificateur, identification d'un état d'erreur quand la valeur de tension au niveau de la sortie d'amplificateur (Vout) se règle en dehors d'une seconde plage de valeurs théoriques pour des valeurs plausibles de la tension de différence entre le premier raccord de mesure (+UD) et le second raccord de mesure (-UD) multipliée par l'amplification de tension (G) ou à l'intérieur de la première plage de valeurs théoriques.

10. Procédé servant à identifier des erreurs selon la revendication 8 ou 9, contenant en supplément des étapes suivantes : sauvegarde d'un état d'erreur identifié aux fins d'un traitement ultérieur et/ou déclenchement d'une alarme et/ou signalisation d'une modification d'état de fonctionnement.

11. Procédé selon la revendication 8, 9 ou 10, dans lequel celui-ci est codé dans un programme informatique, lequel est exécuté par un contrôleur.

12. Procédé selon la revendication 8, 9, 10 ou 11, dans lequel il est exécuté dans un dispositif servant à l'administration parentérale d'un médicament.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9901777 A1
- EP 2269009 B1
- WO 2014170051 A1
- EP 2511713 A